# EUROPEAN PATENT SPECIFICATION

(11) **EP 3 048 408 B1**
(45) Date of publication and mention of the grant of the patent: **01.05.2019**
(21) Application number: 16151145.6
(22) Date of filing: 13.01.2016
(51) Int. Cl.: F28F 3/12, B22F 3/105, F28D 20/02, H01L 23/373

(54) **COMPOSITE PASSIVE HEAT SINK SYSTEM AND METHOD**
PASSIVES ZUSAMMENGESETZTES KÜHLKÖRPERSYSTEM UND VERFAHREN
SYSTÈME DE DISSIPATEUR DE CHALEUR PASSIF COMPOSITE ET PROCÉDÉ

(30) Priority: 15.01.2015 US 201514597703
(43) Date of publication of application: 27.07.2016
(73) Proprietor: Hamilton Sundstrand Space Systems International, Inc., Windsor Locks, CT 06096 (US)
(72) Inventor: STIEBER, Jesse Joseph, Avon, CT Connecticut 06001 (US)
(74) Representative: Dehns

(56) References cited:
- EP-A2- 0 732 743
- DE-A1- 10 065 594
- DE-A1-102004 032 093
- US-A- 5 007 478
- US-A- 5 039 577
- US-A1- 2011 056 650
- US-A1- 2012 240 919

## Description

### FIELD

The present disclosure relates heat sinks, and more particularly, to systems and methods of increasing the efficiency of heat sinks.

### BACKGROUND

A heat sink may be configured to transfer thermal energy from a higher temperature component to a lower temperature medium, such as a fluid medium. If the fluid medium is water, the heat sink may be referred to as a cold plate. In thermodynamics, a heat sink is a heat reservoir configured to absorb heat without significantly changing temperature. Heat sinks for electronic devices often have a temperature higher than the surroundings to transfer heat by convection, radiation, and/or conduction.

To understand the principle of a heat sink, consider Fourier's law of heat conduction. Fourier's law states that the rate of heat flow, dQ/dt, through a homogeneous solid is directly proportional to the area, A, of the section at right angles to the direction of heat flow, and to the temperature difference along the path of heat flow, dT/dx. (The proportionality ratio, λ, is the thermal conductivity of the material). Resulting in: dQ/dt = - λ A dT/dx.

Heat sink systems are taught in EP 0732743, US 5,039,577, US 5,007,478 and DE 100 65 594.

### SUMMARY

The present disclosure relates to a passive heat sink system as defined by claim 1.

The passive heat sink system may include a heat sink surface disposed on an external surface of the enclosure. A wetted coupling is formed between an interface between the conductive matrix and a surface of the enclosure in response to the additive manufacturing process occurring. The additive manufacturing process comprises successive layers of material being laid down under computer control to form a component. The additive manufacturing process comprises at least one of direct metal laser sintering, selective laser melting, or selective laser sintering. The flow of heat from a heat sink surface to the conductive matrix is direct through the enclosure to the conductive matrix. Stated another way, the coupling of the enclosure to the conductive matrix is free of intervening adhesives and/or bonding agents. The conductive matrix comprises a graphite matrix.

According to another aspect, a method of forming a passive heat sink is provided as defined by claim 9.

The heat sink assembly enclosure may include a port configured to pass through at least one of the first portion of the heat sink assembly enclosure or the second portion of the heat sink assembly enclosure to the internal cavity. A phase change material may be added to the internal cavity via the port. A heat sink surface may be disposed on an external surface of at least one of the first portion of the heat sink assembly enclosure or the second portion of the heat sink assembly enclosure. A wetted coupling is formed between an interface between the conductive matrix and a surface of at least one of the first portion of the heat sink assembly enclosure or the second portion of the heat sink assembly enclosure in response to the additive manufacturing process occurring.

### BRIEF DESCRIPTION OF THE DRAWINGS

The subject matter of the present disclosure is particularly pointed out and distinctly claimed in the concluding portion of the specification. A more complete understanding of the present disclosure, however, may best be obtained by referring to the detailed description and claims when considered in connection with the drawing figures, wherein like numerals denote like elements.
FIG. 1 depicts a representative heat sink device in accordance with various embodiments;
FIG. 2 depicts a representative composite passive heat sink, in accordance with various embodiments;
FIG. 3 depicts the cross-sectional view of the heat sink of FIG. 2, in accordance with various embodiments; and
FIG. 4 depicts a method for creating a composite passive heat sink assembly in accordance with various embodiments.

### DETAILED DESCRIPTION

The detailed description of exemplary embodiments herein makes reference to the accompanying drawings, which show exemplary embodiments by way of illustration and their best mode. While these exemplary embodiments are described in sufficient detail to enable those skilled in the art to practice the disclosure, it should be understood that other embodiments may be realized and that logical changes may be made without departing from the scope of the disclosure. Thus, the detailed description herein is presented for purposes of illustration only and not of limitation. For example, the steps recited in any of the method or process descriptions may be executed in any order and are not necessarily limited to the order presented. Furthermore, any reference to singular includes plural embodiments, and any reference to more than one component or step may include a singular embodiment or step.

The present disclosure relates to a heat sink, and more particularly a heat sink with desirable thermally conductive joints. Conventionally, phase change material (PCM) heat sinks use water, wax, fluid, or other materials with desirable melting points to store and release the heat energy associated with the solid liquid phase change, called the latent heat of fusion. A traditional heat sink is made from a common material (i.e. aluminum or stainless steel), the joining of the different parts, fin or metal matrix to a thermal interface sheet is commonly done through a traditional braze process. This creates a structural and thermally conductive joint. These types of homogenous PCM heat sinks have a low PCM to structure mass ratio. To increase the PCM to structure mass ratio a highly conductive light weight matrix material may be utilized, the highly conductive light weight matrix materials are typically nonmetal materials. Conventionally, when joining the nonmetal matrix to a metal thermal interface sheet, a bond or glue is applied between the nonmetal matrix and the thermal interface, (e.g., heat sink surface). This creates a weak structural joint and a less than desirable thermally conductive joint. The glue adds a thermal resistance to the heat transfer path which is not present in a typical all metal joint.

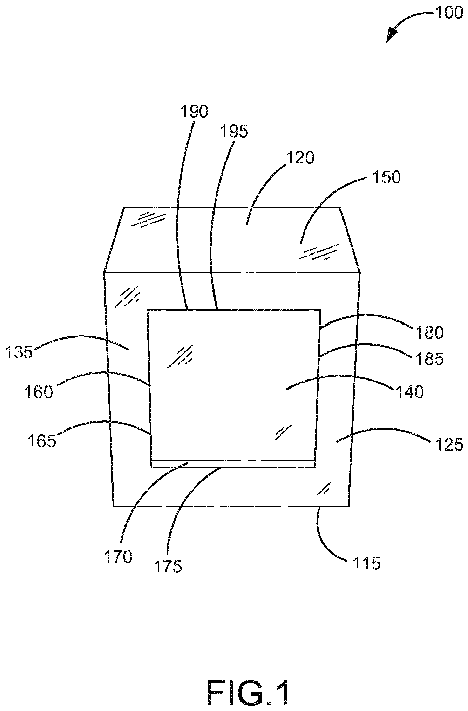

According to various embodiments and with reference to FIG. 1 a passive heat sink is depicted. An enclosure 150 housing a nonmetal matrix composite component 140 is depicted. At least one surface, such as top surface 120, of the enclosure 150 may be in contact and/or close proximity to a heat source. The nonmetal matrix composite component 140 may comprise any nonmetal matrix composite materials, for instance the nonmetal matrix composite may be a graphite matrix, such as Poco Foam®. Adhering the nonmetal matrix composite component 140 to the enclosure with adhesive may result in poor thermal conductivity through the adhesive. The systems and methods described herein may mitigate these thermal conductivity concerns.

According to various embodiments, an assembly 100 is formed. The assembly 100 comprises an enclosure 150. The enclosure 150 is formed through an additive manufacturing process. Specifically, the enclosure 150 may be formed through an additive manufacturing process while the partially formed enclosure is in contact with a nonmetal matrix composite component 140. Additive manufacturing is the use of one of various processes to make a three-dimensional component.

Additive manufacturing may comprise successive layers of material being laid down under computer control to form a component. These objects can be of almost any shape or geometry, and are produced from a three dimensional model or other electronic data source.

Additive manufacturing processes include direct metal laser sintering (DMLS). DMLS is an additive manufacturing technique that uses a laser as a power source to sinter powdered material (typically metal), aiming the laser automatically at points in space defined by a 3D model, binding material together to create a solid structure. Additive manufacturing processes include selective laser melting. Selective laser melting is a process that uses 3D data, such as 3D CAD data, as a digital information source and energy in the form of a high-power laser beam (such as a ytterbium fiber laser) to create a three-dimensional metal component by fusing metallic powders together. Additive manufacturing processes include selective laser sintering (SLS) SLS is a technique that uses a laser as a power source to sinter powdered material (typically metal), aiming the laser automatically at points in space defined by a 3D model, binding the material together to create a solid structure. It is similar to DMLS.

The enclosure 150 may comprise at least one of a base 115, first side wall 135, second side wall 125 and top surface 120. Any surface, such as an external surface, of the enclosure 150 may comprise a heat sink surface. According to various embodiments, enclosure 150 may be partially formed. For instance, least one of a base 115, first side wall 135, second side wall 125 and top surface 120 may be formed, such as through an additive manufacturing process. A nonmetal matrix composite component 140 may be inserted within the partially formed enclosure 150. An integral bond may be formed between the exterior walls of the nonmetal matrix composite component 140 and the interior walls of the enclosure 150. For instance, the nonmetal matrix composite component 140 may comprise a first side wall 160, a second side wall 180, a top surface 190 and a bottom surface 170. The enclosure 150 may comprise an interior first side wall 165, a second interior side wall 185, an interior top surface 195, and an interior base surface 175. The interior shape and size of the enclosure 150 may be sized to approximately mirror the exterior shape and size of the nonmetal matrix composite component 140. Wetted bonds are formed between at least one of the first side wall 160 and the interior first side wall 165; the second side wall 180 and the second interior side wall 185; the top surface 190 and the interior top surface 195; or the bottom surface 170 and an interior base surface 175. Wetting is the ability of a liquid to maintain contact with a solid surface, resulting from intermolecular interactions when the two are brought together. The degree of wetting (wettability) is determined by a force balance between the adhesive and cohesive forces present. In this way, the high heat conditions of the additive manufacturing process forming the enclosure 150 around the nonmetal matrix composite component 140 causes a wetted condition to occur.

According to various embodiments, the high heat conditions of the additive manufacturing process forming the enclosure 150 around the nonmetal matrix composite component 140 and/or inserting the nonmetal matrix composite component 140 in a partially formed and still hot enclosure 150 cause a bond between adjacent dissimilar material surfaces to occur.

According to various embodiments, in this way the conduction path is efficient as no foreign bonding agents are present. Stated another way, a glueless, bondless, coupling between the enclosure 150 and the nonmetal matrix composite component 140 creates an efficient conduction path, such as for a heat sink. By forming the enclosure 150 around the nonmetal matrix composite component 140, concerns of differences in thermal expansion between the enclosure 150 and the nonmetal matrix composite component 140 are mitigated. The flow of heat from a top surface 120 (e.g., heat sink surface) to the matrix composite component 140 is direct through the enclosure 150 to the matrix composite component 140. Stated another way, the coupling of the enclosure 150 to the matrix composite component 140 is free of intervening adhesives and/or bonding agents.

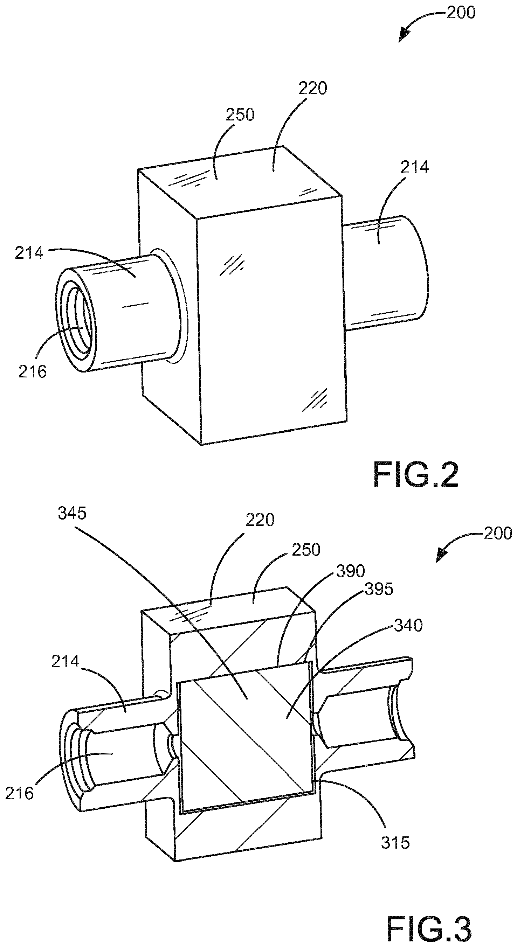

According to various embodiments, and with reference to FIGs. 2 and 3, a passive heat sink assembly 200 is depicted. Passive heat sink assembly 200 comprises an enclosure 250 which defines an internal cavity 315. A conductive matrix 340 may substantially fill the internal cavity 315. As described above with reference to assembly 100, enclosure 250 may be additively manufactured around the conductive matrix 340. The conductive matrix 340 may be made from any desired material; however, in various embodiments, the conductive matrix is a porous graphite matrix. The internal cavity may further comprise a phase change material (PCM) 345, such as wax. PCM 345 may be added to the internal cavity 315 at any time; however, according to various embodiments, PCM 345 is added to internal cavity 315 via port 216 of tube 214. Port 216 may be configured to pass through an external surface of the enclosure 250 to the internal cavity 315. Tube 214 may be closed in response to a desired volume of PCM 345 around conductive matrix 340 within internal cavity 315 being reached. The top surface 220 of enclosure 250 may be a heat sink surface. In this way, thermal energy may be transferred through top surface 220, across the efficient conductive interface between the interior top surface 395 of enclosure 250 to the top surface 390 of conductive matrix 340. The PCM 345 may store the energy by undergoing a phase change.

As described herein an additive manufacturing process is utilized to encapsulate a nonmetal matrix, such as conductive matrix 340 and create structural and thermally conductive joint at the thermal interface between conductive matrix 340 and its enclosure, such as enclosure 250. This is achieved via the metal of enclosure 250 wetting to the conductive matrix 340 which creates the passive heat sink assembly 200. Due it its lack of thermally resistive bonds at the metal to high conductivity matrix interface, passive heat sink assembly 200 has improved the heat transfer characteristics as compared with conventional heat sinks. The structural capacity of the passive heat sink assembly 200 is limited by the strength of the matrix not its bond joints.

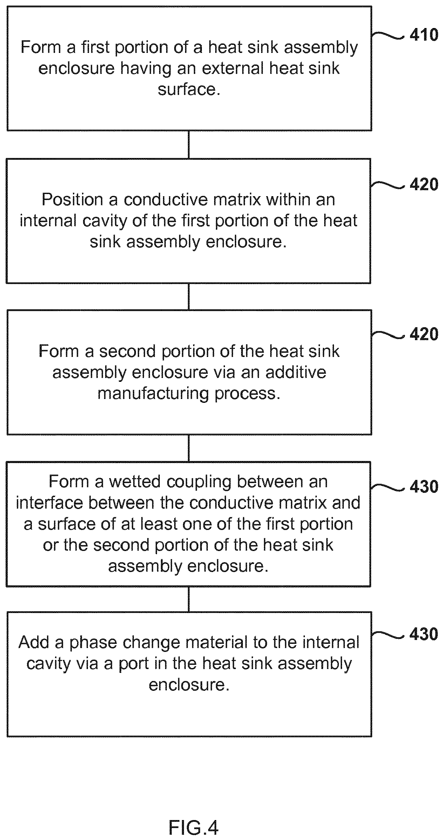

According to various embodiments, and with reference to FIG. 4, a method for creating a passive heat sink assembly 200, such as a composite passive heat sink assembly is described. The method includes, forming a first portion of a heat sink assembly enclosure having an external heat sink surface (Step 410). The first portion may comprise at least one of a base or one or more side walls. A conductive matrix is positioned within an internal cavity of the first portion of the heat sink assembly enclosure (Step 420). This positioning may by any suitable process. For instance, the conductive matrix may be formed within the first portion of the heat sink assembly enclosure, such as by an additive manufacturing process, substantially in concert with the formation of at least one of first portion of the heat sink assembly enclosure or the second portion of the heat sink assembly enclosure. A second portion of the heat sink assembly enclosure may be formed via an additive manufacturing process. (Step 420) A wetted coupling is made between an interface between the conductive matrix and a surface of at least one of the first portion or the second portion of the heat sink assembly enclosure (Step 430). A phase change material may be added to the internal cavity via a port formed in the heat sink assembly enclosure (Step 430).

Benefits, other advantages, and solutions to problems have been described herein with regard to specific embodiments. Furthermore, the connecting lines shown in the various figures contained herein are intended to represent exemplary functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the disclosure. The scope of the disclosure is accordingly to be limited by nothing other than the appended claims, in which reference to an element in the singular is not intended to mean "one and only one" unless explicitly so stated, but rather "one or more."

Systems, methods and apparatus are provided herein. In the detailed description herein, references to "various embodiments", "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments. Different cross-hatching is used throughout the figures to denote different parts but not necessarily to denote the same or different materials.

## Claims

1. A passive heat sink system comprising:
an enclosure (150;250) defining an internal cavity (315);
a conductive matrix (340) disposed within the internal cavity (315);
a phase change material (345) at least partially collocated with the conductive matrix (340) within the internal cavity (315); **characterised in that**
the enclosure (150;250) is at least partially formed around the conductive matrix (340) via an additive manufacturing process; and wherein a wetted coupling is formed between an interface between the conductive matrix (340) and a surface of the enclosure (150;250) in response to the additive manufacturing process occurring.

2. The passive heat sink system of claim 1, further comprising a port (216) configured to pass through an external surface of the enclosure (150;250) to the internal cavity (315).

3. The passive heat sink system of claim 2, wherein the phase change material (345) is added to the internal cavity (315) via the port (216).

4. The passive heat sink system of claim 1, 2 or 3, further comprising a heat sink surface (120;220) disposed on an external surface (120;220) of the enclosure (150;250).

5. The passive heat sink system of any preceding claim, wherein the additive manufacturing process comprises successive layers of material laid down under computer control to form a component.

6. The passive heat sink system of any preceding claim, wherein the additive manufacturing process comprises at least one of direct metal laser sintering, selective laser melting, or selective laser sintering.

7. The passive heat sink system of any preceding claim, wherein a flow of heat from a/the heat sink surface (150;250) to the conductive matrix (340) is direct through the enclosure (150;250) to the conductive matrix (340).

8. The passive heat sink system of any preceding claim, wherein the conductive matrix (340) comprises a graphite matrix.

9. A method comprising:
forming a first portion of a heat sink assembly enclosure (150;250);
positioning a conductive matrix (340) within an internal cavity (315) of the first portion of the heat sink assembly enclosure (150;250); and
forming a second portion of the heat sink assembly enclosure (150;250); **characterised in that** at least one of the first portion of the heat sink assembly enclosure (150;250) or the second portion of the heat sink assembly enclosure (150;250) is formed via an additive manufacturing process; and further comprising forming a wetted coupling between an interface between the conductive matrix (340) and a surface of at least one of the first portion of the heat sink assembly enclosure (150;250) or the second portion of the heat sink assembly enclosure (150;250) in response to the additive manufacturing process occurring.

10. The method of claim 9, further comprising forming a port (216) configured to pass through at least one of the first portion of the heat sink assembly enclosure (150;250) or the second portion of the heat sink assembly enclosure (150;250) to the internal cavity (315).

11. The method of claim 10, further comprising adding a phase change material (345) to the internal cavity (315) via the port (216).

12. The method of claim 9 or 10, wherein a heat sink surface (120;220) is disposed on an external surface (120;220) of at least one of the first portion of the heat sink assembly enclosure (150;250) or the second portion of the heat sink assembly enclosure (150;250).

13. The method of any of claims 9 to 12, wherein the additive manufacturing process comprises at least one of direct metal laser sintering, selective laser melting, or selective laser sintering.

## Patentansprüche

1. Passives Kühlkörpersystem, umfassend:
ein Gehäuse (150;250), das einen inneren Hohlraum (315) definiert;
eine leitfähige Matrix (340), die innerhalb des inneren Hohlraums (315) angeordnet ist;
ein Phasenwechselmaterial (345), das sich zumindest teilweise zusammen mit der leitfähigen Matrix (340) innerhalb des inneren Hohlraums (315) befindet; **dadurch gekennzeichnet, dass**
das Gehäuse (150;250) durch einen additiven Herstellungsprozess zumindest teilweise um die leitfähige Matrix (340) gebildet ist;
und wobei eine benetzte Kupplung zwischen einer Schnittstelle zwischen der leitfähigen Matrix (340) und einer Oberfläche des Gehäuses (150; 250) als Reaktion auf den erfolgenden additiven Herstellungsprozess ausgebildet ist.

2. Passives Kühlkörpersystem nach Anspruch 1, ferner umfassend einen Kanal (216), der so konfiguriert ist, dass er durch eine äußere Oberfläche des Gehäuses (150;250) zum inneren Hohlraum (315) hindurchgeht.

3. Passives Kühlkörpersystem nach Anspruch 2, wobei das Phasenwechselmaterial (345) dem inneren Hohlraum (315) über den Kanal (216) hinzugefügt wird.

4. Passives Kühlkörpersystem nach Anspruch 1, 2 oder 3, ferner umfassend eine Kühlkörperoberfläche (120;220), die auf einer äußeren Oberfläche (120;220) des Gehäuses (150;250) angeordnet ist.

5. Passives Kühlkörpersystem nach einem der vorhergehenden Ansprüche, wobei der additive Herstellungsprozess aufeinanderfolgende Materialschichten umfasst, die computergesteuert abgelegt werden, so dass sie eine Komponente bilden.

6. Passives Kühlkörpersystem nach einem der vorhergehenden Ansprüche, wobei der additive Herstellungsprozess mindestens eines von Direktmetalllasersintern, selektivem Laserschmelzen oder selektivem Lasersintern umfasst.

7. Passives Kühlkörpersystem nach einem der vorhergehenden Ansprüche, wobei ein Wärmestrom von einer/der Kühlkörperoberfläche (150;250) zur leitfähigen Matrix (340) direkt durch das Gehäuse (150;250) zur leitfähigen Matrix (340) erfolgt.

8. Passives Kühlkörpersystem nach einem der vorhergehenden Ansprüche, wobei die leitfähige Matrix (340) eine Graphitmatrix umfasst.

9. Verfahren, umfassend:
Bilden eines ersten Abschnitts eines Kühlkörperbaugruppengehäuses (150;250)
Positionieren einer leitfähigen Matrix (340) innerhalb eines inneren Hohlraums (315) des ersten Abschnitts des Kühlkörperbaugruppengehäuses (150;250); und
Bilden eines zweiten Abschnitts eines Kühlkörperbaugruppengehäuses (150;250); **dadurch gekennzeichnet, dass** mindestens einer des ersten Abschnitts des Kühlkörperbaugruppengehäuses (150;250) oder des zweiten Abschnitts des Kühlkörperbaugruppengehäuses (150;250) über einen additiven Herstellungsprozess gebildet ist; und ferner umfassend das Bilden einer benetzten Kupplung zwischen einer Schnittstelle zwischen der leitfähigen Matrix (340) und einer Oberfläche von mindestens einem des ersten Abschnitts des Kühlkörperbaugruppengehäuses (150;250) oder des zweiten Abschnitts des Kühlkörperbaugruppengehäuses (150;250) als Reaktion auf den erfolgenden additiven Herstellungsprozess.

10. Verfahren nach Anspruch 9, ferner umfassend das Bilden eines Kanals (216), der so konfiguriert ist, dass er durch mindestens einen des ersten Abschnitts der Kühlkörperbaugruppengehäuses (150;250) oder des zweiten Abschnitts des Kühlkörperbaugruppengehäuses (150;250) zum inneren Hohlraum (315) hindurchgeht.

11. Verfahren nach Anspruch 10, ferner umfassend das Hinzufügen eines Phasenwechselmaterials (345) zum inneren Hohlraum (315) über einen Kanal (216).

12. Verfahren nach Anspruch 9 oder 10, wobei die Kühlkörperoberfläche (120;220) auf einer äußeren Oberfläche (120;220) von mindestens einem des ersten Abschnitts des Kühlkörperbaugruppengehäuses (150;250) oder des zweiten Abschnitts des Kühlkörperbaugruppengehäuses (150;250) angeordnet ist.

13. Verfahren nach einem der Ansprüche 9 bis 12, wobei der additive Herstellungsprozess mindestens eines von Direktmetalllasersintern, selektivem Laserschmelzen oder selektivem Lasersintern umfasst.

## Revendications

1. Système de dissipateur de chaleur passif comprenant :
une enceinte (150 ; 250) définissant une cavité interne (315) ;
une matrice conductrice (340) disposée au sein de la cavité interne (315) ;
un matériau à changement de phase (345) au moins partiellement co-localisé avec la matrice conductrice (340) au sein de la cavité interne (315) ; **caractérisé en ce que**
l'enceinte (150 ; 250) est au moins partiellement formée autour de la matrice conductrice (340) via un processus de fabrication additive ; et dans lequel un couplage mouillé est formé entre une interface entre la matrice conductrice (340) et une surface de l'enceinte (150 ; 250) en réponse à la survenue du processus de fabrication additive.

2. Système de dissipateur de chaleur passif selon la revendication 1, comprenant en outre un orifice (216) configuré pour passer à travers une surface externe de l'enceinte (150 ; 250) vers la cavité interne (315).

3. Système de dissipateur de chaleur passif selon la revendication 2, dans lequel le matériau à changement de phase (345) est ajouté à la cavité interne (315) via l'orifice (216).

4. Système de dissipateur de chaleur passif selon la revendication 1, 2 ou 3, comprenant en outre une surface de dissipateur de chaleur (120 ; 220) disposée sur une surface externe (120 ; 220) de l'enceinte (150 ; 250).

5. Système de dissipateur de chaleur passif selon une quelconque revendication précédente, dans lequel le processus de fabrication additive comprend des couches successives de matériau déposées sous la commande d'un ordinateur pour former un composant.

6. Système de dissipateur de chaleur passif selon une quelconque revendication précédente, dans lequel le processus de fabrication additive comprend au moins l'un parmi un frittage direct au laser à métaux, une fusion sélective au laser ou un frittage sélectif au laser.

7. Système de dissipateur de chaleur passif selon une quelconque revendication précédente, dans lequel un flux de chaleur allant d'une/de la surface de dissipateur de chaleur (150 ; 250) à la matrice conductrice (340) est direct à travers l'enceinte (150 ; 250) vers la matrice conductrice (340).

8. Système de dissipateur de chaleur passif selon une quelconque revendication précédente, dans lequel la matrice conductrice (340) comprend une matrice de graphite.

9. Procédé comprenant :
la formation d'une première portion d'une enceinte d'ensemble dissipateur de chaleur (150 ; 250) ;
le positionnement d'une matrice conductrice (340) au sein d'une cavité interne (315) de la première portion de l'enceinte d'ensemble dissipateur de chaleur (150 ; 250) ; et
la formation d'une seconde portion de l'enceinte d'ensemble dissipateur de chaleur (150 ; 250) ; **caractérisé en ce qu'**au moins l'une de la première portion de l'enceinte d'ensemble dissipateur de chaleur (150 ; 250) ou de la seconde portion de l'enceinte d'ensemble dissipateur de chaleur (150 ; 250) est formée via un processus de fabrication additive ; et comprenant en outre la formation d'un couplage mouillé entre une interface entre la matrice conductrice (340) et une surface d'au moins l'une de la première portion de l'enceinte d'ensemble dissipateur de chaleur (150 ; 250) ou la seconde portion de l'enceinte d'ensemble dissipateur de chaleur (150 ; 250) en réponse à la survenue du processus de fabrication additive.

10. Procédé selon la revendication 9, comprenant en outre la formation d'un orifice (216) configuré pour passer à travers au moins l'une de la première portion de l'enceinte d'ensemble dissipateur de chaleur (150 ; 250) ou de la seconde portion de l'enceinte d'ensemble dissipateur de chaleur (150 ; 250) vers la cavité interne (315).

11. Procédé selon la revendication 10, comprenant en outre l'ajout d'un matériau à changement de phase (345) à la cavité interne (315) via l'orifice (216).

12. Procédé selon la revendication 9 ou 10, dans lequel une surface de puits de chaleur (120 ; 220) est disposée sur une surface externe (120 ; 220) d'au moins l'une de la première portion de l'enceinte d'ensemble dissipateur de chaleur (150 ; 250) ou la seconde portion de l'enceinte d'ensemble dissipateur de chaleur (150 ; 250).

13. Procédé selon l'une quelconque des revendications 9 à 12, dans lequel le processus de fabrication additive comprend au moins l'un parmi un frittage direct au laser à métaux, une fusion sélective au laser ou un frittage sélectif au laser.
